# EUROPÄISCHE PATENTSCHRIFT

(11) **EP 0 623 958 B1**
(45) Veröffentlichungstag und Bekanntmachung des Hinweises auf die Patenterteilung: **01.04.1998**
(21) Anmeldenummer: 93107222.7
(22) Anmeldetag: 04.05.1993
(51) Int. Cl.: H01L 27/02

(54) **Integrierte Halbleiterschaltung mit einem Schutzmittel**
Semi-conductor integrated circuit including protection means
Circuit intégré semi-conducteur comprenant des moyens de protection

(43) Veröffentlichungstag der Anmeldung: 09.11.1994
(73) Patentinhaber: SIEMENS AKTIENGESELLSCHAFT, 80333 München (DE)
(72) Erfinder: Reczek, Werner, Dr.-Ing., W-8012 Ottobrunn (DE); Terletzki, Hartmud, Dipl.-Ing. (TU), W-8012 Ottobrunn (DE)

(56) Entgegenhaltungen:
- US-A- 4 987 465
- ELECTRICAL OVERSTRESS / ELECTROSTATIC DISCHARGE SYMPOSIUM PROCEEDINGS September 1991, LAS VEGA, NEVADA, USA Seiten 88 - 97 C. DUVVURY ET AL. 'A SYNTHESIS OF ESD INPUT PROTECTION SCHEME'
- IEEE TRANSACTIONS ON INDUSTRY APPLICATIONS Bd. 25, Nr. 1, Januar 1989, NEW YORK US Seiten 41 - 47 , XP111241 C. DUVVURY ET AL. 'ESD PROTECTION: DESIGN AND LAYOUT ISSUES FOR VLSI CIRCUITS'

## Beschreibung

Die Erfindung betrifft eine integrierte Halbleiterschaltung mit den Merkmalen des Oberbegriffes von Patentanspruch 1.

Eine solche Halbleiterschaltung ist aus der US-A 4,987,465 und aus der DE-A 39 18 090 bekannt. Integrierte Halbleiterschaltungen, insbesondere MOS-integrierte Halbleiterschaltungen, sind bekanntlich empfindlich gegenüber elektrostatischen Aufladungen (ESD - Electrostatic Discharge), soweit diese auf deren Anschlüsse (Pads am Halbleiterchip; Pins am Halbleiterschaltungsgehause) einwirken. Untersuchungen an den bekannten Halbleiterschaltungen haben gezeigt, daß diese zwar einen gegenüber der Vergangenheit verbesserten Schutz gegen ESD-Einwirkungen aufweisen, aber auch, daß dieser Schutz noch nicht genügend heutigen Wunschvorstellungen entspricht.

Aufgabe der vorliegenden Erfindung ist es, diese bekannten Halbleiterschaltungen so weiterzubilden, daß diese auch höheren Anforderungen an ESD-Schutz entsprechen. Diese Aufgabe wird gelöst mit den kennzeichnenden Mitteln des Patentanspruches 1. Vorteilhafte Aus- und Weiterbildungen sind in Unteransprüchen gekennzeichnet.

Die Erfindung wird nachstehend anhand von Ausführungsbeispielen mittels der Zeichnung näher erläutert. Dabei zeigen
- die Figur 1:: eine schematische Darstellung wesentlicher Teile einer erfindungsgemäßen Halbleiterschaltung,
- die Figuren 2 bis 8, 10 bis 12:: Einzelheiten, dargestellt teils schematisch, teils in Draufsicht, teils im Querschnitt
- Figur 9:: eine vorteilhafte Ausgestaltung bei sogenannten I/O-Anschlüssen,
- die Figuren 13 bis 21:: vorteilhafte Weiterbildungen der Erfindung, ausschnittsweise.

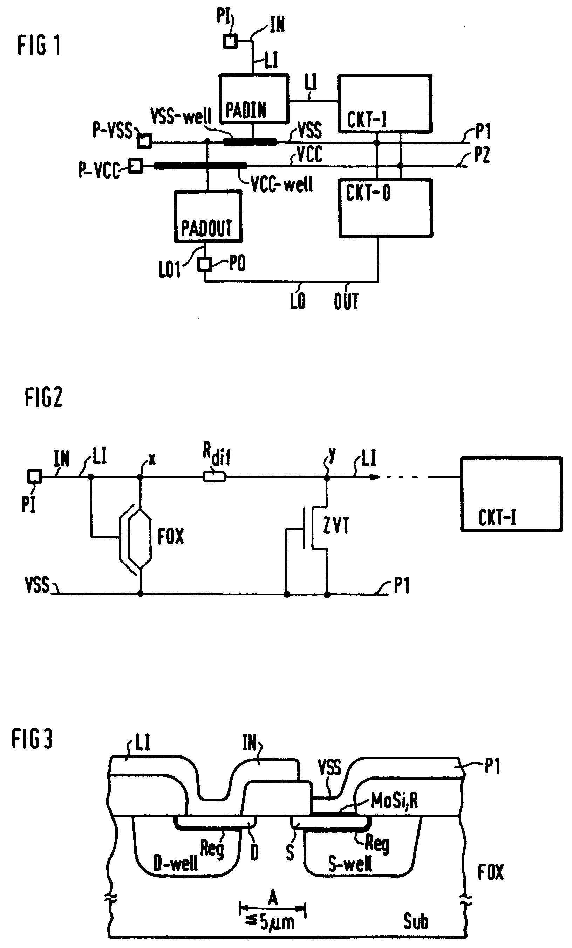

In den Figuren sind dargestellte Oxidbereiche stets allgemein mit "Ox" bezeichnet. Gemäß Figur 1 enthält die erfindungsgemäße Halbleiterschaltung erste Schaltungsteile CKT-I und zweite Schaltungsteile CKT-O (aus Gründen der Übersichtlichkeit sind nur jeweils ein erster und ein zweiter Schaltungsteil dargestellt). Jeder erste Schaltungsteil CKT-I dient dem Empfang und der Weiterverarbeitung eines Eingangssignals IN, welches, wie üblich, beim Betrieb der Halbleiterschaltung an einen entsprechenden Anschluß PI angelegt wird. Bei einem integrierten Schaltkreis mit Gehäuse nennt man solche Anschlüsse üblicherweise Pins; beim Halbleiterchip selbst werden sie Pad genannt. Jeder zweite Schaltungsteil CKT-O erzeugt im Betrieb ein Ausgangssignal OUT der Halbleiterschaltung, welches dann über einen entsprechenden Anschluß PO (ebenfalls Pin bzw. Pad genannt) schaltkreisextern zur Verfügung gestellt wird. Als Spannungsversorgung dienen (wenigstens) ein erstes Versorgungspotential VSS (meist Masse bzw. Ground genannt) und ein zweites Versorgungspotential VCC. Die Versorgungspotentiale VSS, VCC werden der Halbleiterschaltung im Betrieb über entsprechende Potentialanschlüsse P-VSS, P-VCC zugeführt. Innerhalb der Halbleiterschaltung werden die ersten und zweiten Versorgungspotentiale VSS, VCC in Form von ersten und zweiten Potentialschienen P1, P2 nach Art von Potentialbussen geführt zur Spannungsversorgung der Schaltungsteile CKT-I, CKT-O.

Die integrierte Halbleiterschaltung enthält weiterhin eine Schutzanordnung gegen Überspannungen (ESD-Schutz) mit ersten und zweiten Schutzschaltungen PADIN, PADOUT. Jede erste Schutzschaltung PADIN ist zwischen einem Anschluß PI für ein entsprechendes Eingangssignal IN und dem diesem Anschluß PI zugehörigen ersten Schaltungsteil CKT-I angeordnet. Eine ein solches Eingangssignal IN führende Leitung, welche den Anschluß PI zunächst mit der ersten Schutzschaltung PADIN und anschließend diese mit dem ersten Schaltungsteil CKT-I verbindet, wird nachstehend mit LI bezeichnet.

Eine erste Schutzschaltung PADIN ist, wie in Figur 2 dargestellt, folgendermaßen aufgebaut: Zwischen der das jeweilige Eingangssignal IN führenden Leitung LI und der ersten Potentialschiene P1 ist ein Feldoxidtransistor FOX angeordnet, dessen Gate mit der Leitung LI verbunden ist. Der Anschlußpunkt des Feldoxidtransistors FOX an die Leitung LI sei mit "x" bezeichnet. Im weiteren Verlauf der Leitung LI ist, anschließend an den Punkt x, ein Diffusionswiderstand R_{dif} angeordnet, an dessen Ende oder kurz danach sich der eine Anschluß einer feldgesteuerten Diode ZVT befindet. Der andere Anschluß der feldgesteuerten Diode ZVT ist ebenfalls mit der ersten Potentialschiene P1 verbunden. Der eine Anschluß der feldgesteuerten Diode ZVT bildet dabei einen weiteren Punkt y der Leitung LI. In den Ausführungsbeispielen ist angenommen, daß die feldgesteuerte Diode ZVT als sogenannter Null-Volt-Transistor (Zero-Voltage-Transistor) ausgeführt ist. Andere Ausführungsformen feldgesteuerter Dioden sind möglich und als solche dem Fachmann bekannt. Bei dem als feldgesteuerte Diode ZVT fungierenden Null-Volt-Transistor nach Figur 2 ist das die Feldsteuerung bewirkende Gate (ebenfalls wie seine Source) mit der ersten Potentialschiene P1 verbunden.

Die Source- und Drain-Bereiche des Feldoxidtransistors FOX sind, wie üblich, als Diffusionsgebiete ausgelegt (Source-Bereich S, Drain-Bereich D). Unterhalb des Source-Bereiches S und unterhalb des Drain-Bereiches D ist jeweils ein wannenförmiger Bereich S-well bzw. D-well ausgebildet. Diese wannenförmigen Bereiche S-well, D-well sind im Abstand zueinander angeordnet, wie in Figur 3 gezeigt. Sie sind vom selben Leitungstyp wie der jeweilige Source- bzw. Drain-Bereich S, D.

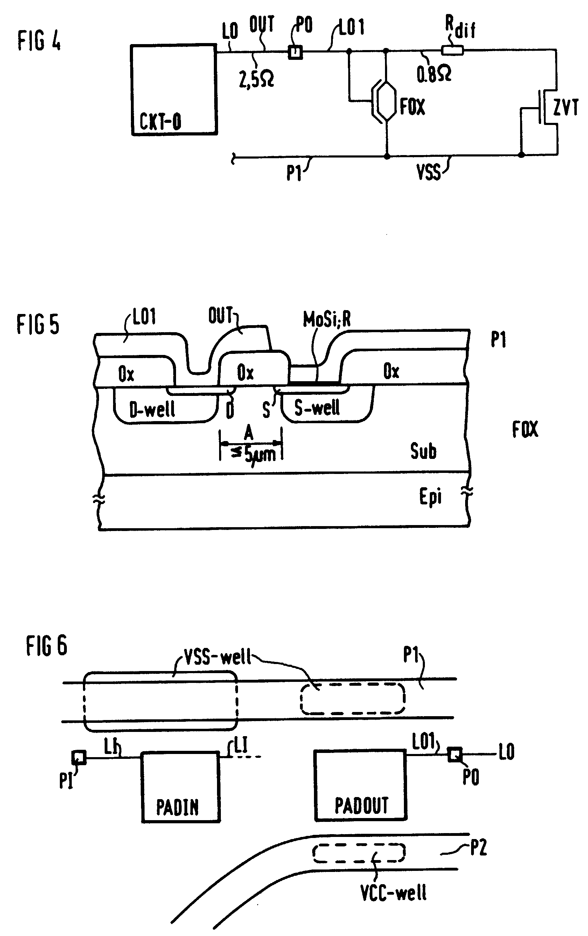

Die zweiten Schutzschaltungen PADOUT sind entsprechend den ersten Schutzschaltungen PADIN aufgebaut. Sie sind jedoch anders angeordnet als diese. Während die ersten Schutzschaltungen PADIN zwischen einem jeweiligen Anschluß PI für ein Eingangssignal IN und einem ersten Schaltungsteil CKT-I angeordnet sind, wie bereits beschrieben, sind bei den zweiten Schutzschaltungen PADOUT die jeweiligen Anschlüsse PO für Ausgangssignale OUT über ein jeweilige entsprechende Leitung LO direkt mit den zweiten Schaltungsteilen CKT-O verbunden und die jeweilige zweite Schutzschaltung PADOUT ist mittels einer (gegenüber der entsprechenden Leitung LO) zusätzlichen Leitung LO1 mit dem jeweiligen Anschluß PO verbunden. Dies ist in den Figuren 1 und 4 dargestellt.

Gemäß dem Vorgesagten und Figur 4 ist eine zweite Schutzschaltung PADOUT mittels einer zusätzlichen Leitung LO1 mit einem entsprechenden, ein Ausgangssignal OUT führenden Anschluß PO verbunden. Sie enthält einen Feldoxidtransistor FOX, welcher zwischen der zusätzlichen Leitung LO1 und der ersten Potentialschiene P1 angeordnet ist. Der mit der zusätzlichen Leitung LO1 verbundene Anschluß des Feldoxidtransistors FOX ist über einen Diffusionswiderstand R_{dif} mit dem einen Anschluß einer feldgesteuerten Diode ZVT verbunden. Der andere Anschluß der feldgesteuerten Diode ZVT wiederum ist mit der ersten Potentialschiene P1 verbunden. Die feldgesteuerte Diode ZVT ist in Figur 4, ebenfalls wie die feldgesteuerte Diode einer ersten Schutzschaltung PADIN nach Figur 2, als Null-Volt-Transistor ausgebildet, dessen Gate zur Durchführung der Feldsteuerung mit der ersten Potentialschiene P1 verbunden ist.

Unterhalb der (ebenfalls als Diffusionsgebiete ausgelegten) Source- und Drain-Bereiche S, D des Feldoxidtransistors FOX sind, entsprechend den ersten Schutzschaltungen PADIN, ebenfalls wannenförmige Bereiche S-well, D-well ausgebildet. Auch diese wannenförmigen Bereiche S-well, D-well sind im Abstand zueinander angeordnet (vergleiche Figur 5) und sie sind vom selben Leitungstyp wie die jeweiligen Source- und Drain-Bereiche S, D.

Wie in den Figuren 1 und 6 gezeigt, enthält die Schutzanordnung der erfindungsgemäßen integrierten Halbleiterschaltung auch wannenförmig ausgebildete Schutzstrukturen VSS-well, VCC-well. Entweder die ersten Potentialschiene P1 oder die zweiten Potentialschiene P2 oder die erste und die zweite Potentialschiene P1, P2 sind in Bereichen, in denen ihnen wenigstens eine der Schutzschaltungen PADIN, PADOUT benachbart ist, mit einer jeweiligen Schutzstruktur VSS-well bzw. VCC-well unterlegt, die mit der jeweiligen Potentialschiene P1 bzw. P2 elektrisch leitend verbunden ist. Die Schutzstrukturen VSS-well, VCC-well sind dabei im Substrat Sub wannenförmig ausgelegt.

Es hat sich erwiesen, daß integrierte Halbleiterschaltungen, welche eine ESD-Schutzanordnung mit den vorbeschriebenen Merkmalen aufweisen, gegen ESD-Ereignisse geschützt sind, deren ESD-Werte, gemessen nach dem Human Body Model, MIL-STD-883C, Methode 3015.7, 4kV und mehr betragen. Ein solcher Schutz ist bei den integrierten Halbleiterschaltungen nach dem beschriebenen Stand der Technik nicht erreichbar.

Vorteilhafterweise sind die Schutzschaltungen PADIN, PADOUT auf dem Halbleiterchip in unmittelbarer Nähe derjenigen Anschlüsse PI, PO (und gegebenenfalls: PIO, die nachstehend noch beschrieben werden) angeordnet, mit denen die jeweilige Schutzschaltung PADIN, PADOUT verbunden ist.

In Figur 5 als eine Ausführungsform eines Feldoxidtransistors FOX einer zweiten Schutzschaltung PADOUT ist der Source-Bereich S des Feldoxidtransistors FOX zum Erzielen eines erhöhten Übergangswiderstandes über eine Molybdän-Silizid-Schicht MoSi mit der ersten Potentialschiene P1 verbunden. Alternativ oder ggf. ergänzend dazu ist auch eine Verbindung des Source-Bereiches S mit der ersten Potentialschiene P1 vorstellbar unter Verwendung eines Widerstandes R, der mindestens das 5-fache des Widerstandes beträgt, der sich ohne Verwendung dieses Widerstandes R als Übergangswiderstand dieser Verbindung ergäbe (ebenfalls dargestellt in Figur 5: Bezugszeichen "R" als Alternative zu "MoSi"). Entsprechendes ist auch möglich beim Source-Bereich S eines Feldoxidtransistors FOX einer ersten Schutzschaltung PADIN, wie in Figur 3 gezeigt. Der mit den vorstehenden Maßnahmen erzielbare Vorteil liegt darin, daß das sogenannte "Spiking" und seine Folgen an Übergängen Leiterbahn/Diffusionsbereich vermieden werden, so daß die ESD-Festigkeit gesteigert ist.

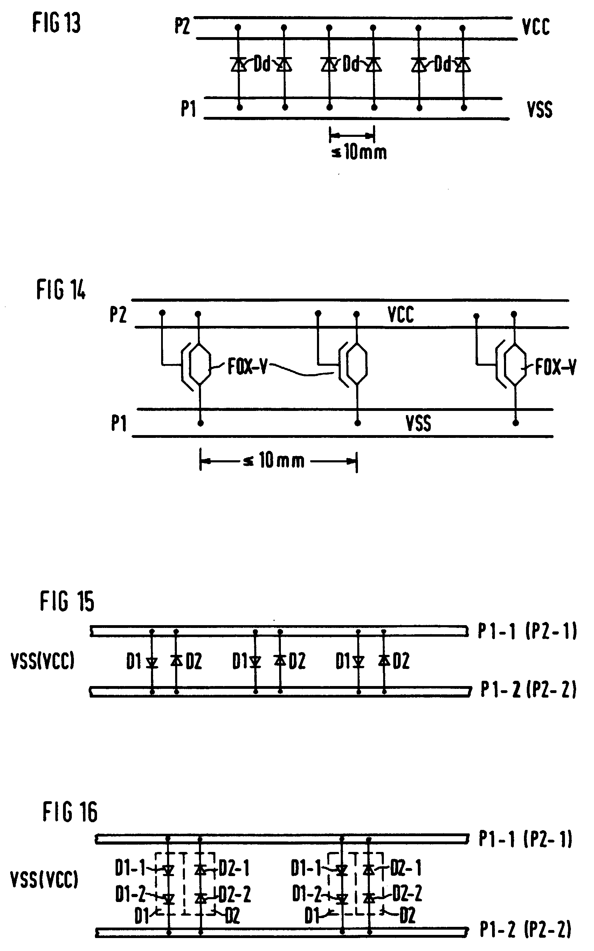

Figur 12 zeigt eine Variante zum vorstehend Gesagten: Dabei ist der Drain-Bereich D eines Feldoxidtransistors FOX einer ersten Schutzschaltung PADIN (bzw. einer zweiten Schutzschaltung PADOUT) mit der das Eingangssignal IN führenden Leitung LI (bzw. mit der mit dem Ausgangssignal OUT behafteten zusätzlichen Leitung LO1) entweder über eine Molybdän-Silizid-Schicht MoSi und/oder unter Verwendung eines Widerstandes R verbunden. Für die Dimensionierung des Widerstandes R sowie Sinn und Zweck dieser Maßnahme gilt dasselbe wie vorstehend im Hinblick auf die Figur 5 gesagt.

In der Ausführungsform nach Figur 6, bei der der Anschluß PI für ein Eingangssignal IN und die jeweilige erste Schutzschaltung PADIN entlang einer oder beider Potentialschienen P1, P2 (z. B. entlang der ersten Potentialschiene P1, wie gezeigt) angeordnet sind, ist es vorteilhaft, wenn die betreffende Schutzstruktur VSS-well (bzw. VCC-well) sich soweit erstreckt, daß sie bis an den jeweiligen Anschluß PI heranreicht. Entsprechendes gilt auch bezüglich eines entsprechenden Anschlusses PO für ein Ausgangssignal und die entsprechende zweite Schutzschaltung PADOUT.

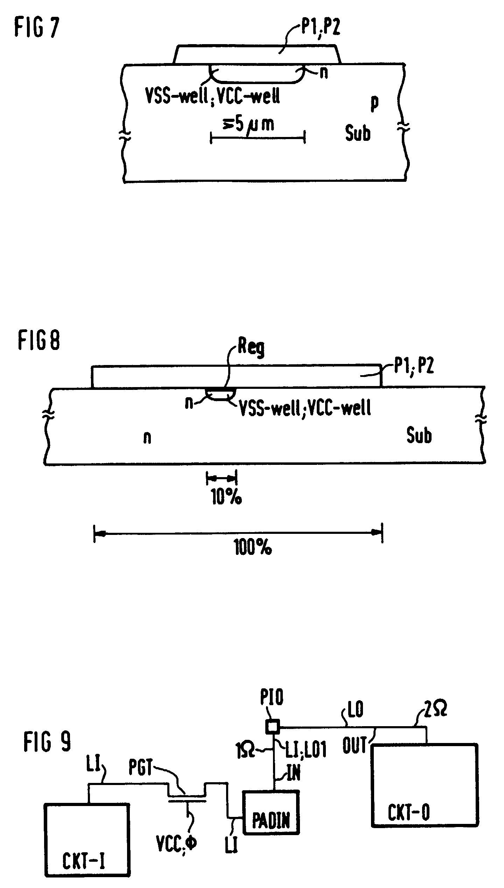

Weiterhin ist es vorteilhaft, wie in den Figuren 6 und 7 gezeigt, wenn die Schutzstrukturen VSS-well bzw. VCC-well mindestens 5µm breit sind oder wenn die Breite einer Schutzstruktur VSS-well bzw. VCC-well, wie in den Figuren 6 und 8 gezeigt, wenigstens 10% der Breite der darüberliegenden jeweiligen Potentialschiene P1 bzw P2 beträgt. Die Schutzstrukturen VSS-well bzw. VCC-well können auch breiter sein als die jeweilige, darüberliegende Potentialschiene P1 bzw. P2 (siehe Figur 6).

Es ist auch günstig, wie in Figur 8 gezeigt, wenn zwischen einer jeweiligen Potentialschiene P1 bzw. P2 und deren zugehöriger Schutzstruktur VSS-well bzw. VCC-well ein Bereich Reg angeordnet ist, der eine gegenüber der Schutzstruktur VSS-well bzw. VCC-well erhöhte Dotierung aufweist. Damit wird ein geringerer Übergangswiderstand zwischen der Potentialschiene und der Schutzstruktur erreicht.

Figur 7 zeigt auch eine weitere vorteilhafte Ausgestaltung der Schutzstrukturen VSS-well bzw. VCC-well: Dabei ist die jeweilige Schutzstruktur VSS-well bzw. VCC-well vom entgegengesetzten Leitungstyp wie das Substrat Sub. Gemäß Figur 8 kann sie jedoch auch vom selben Leitungstyp sein. Wie in Figur 5 gezeigt, kann das Substrat Sub auch auf einer Epi-Schicht Epi angeordnet sein {ebenso wie auch ein SOS-Aufbau (SOS = Silicon On Saphir) möglich ist}.

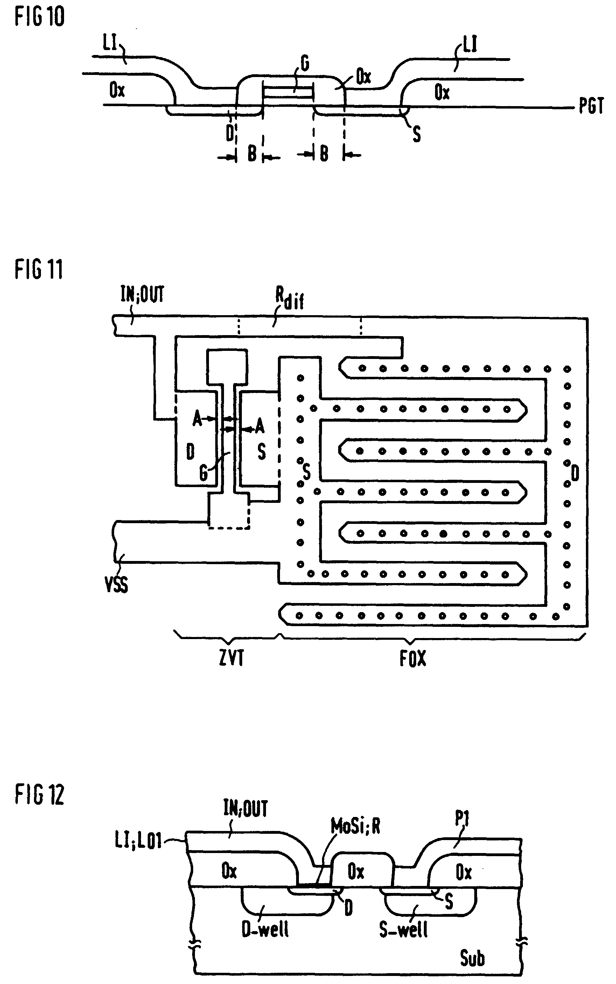

Figur 9 zeigt ausschnittsweise eine integrierte Halbleiterschaltung mit einem Anschluß PIO, welcher im Betrieb sowohl ein Eingangssignal IN wie auch ein Ausgangssignal OUT führen kann (sogenannter I/O-Anschluß). Entsprechend ist an einen solchen Anschluß PIO sowohl ein zweiter Schaltungsteil CKT-O als auch ein erster Schaltungsteil CKT-I angeschlossen. Für einen solchen Anschluß PIO ist lediglich eine einzige, erste Schutzschaltung PADIN vorgesehen, die zwischen dem Anschluß PIO und dem ersten Schaltungsteil CKT-I angeordnet ist. Diese einzige erste Schutzschaltung PADIN weist im Betrieb sowohl die Schutzfunktion als erste Schutzschaltung PADIN wie auch die einer zweiten Schutzschaltung PADOUT auf, wobei derjenige Teil der Leitung LI, der zwischen dem Anschluß PIO und der ersten Schutzschaltung PADIN liegt, bezüglich des zweiten Schaltungsteils CKT-O als weitere Leitung LO1 wirkt.

In der Ausführungsform nach Figur 9 ist zwischen der ersten Schutzschaltung PADIN und dem ersten Schaltungsteil CKT-I ein Pass-Gate-Transistor PGT mit seiner Source-Drain-Strecke angeordnet. Das Gate des Pass-Gate-Transistors PGT ist entweder mit dem zweiten Versorgungspotential VCC verbunden oder mit einem Taktsignal Φ. In dem Fall, in dem im Betrieb das Gate mit dem zweiten Versorgungspotential VCC der Halbleiterschaltung verbunden ist, ist der Pass-Gate-Transistor PGT im Betrieb leitend. Im anderen Fall, in dem im Betrieb das Gate mit dem Taktsignal Φ verbunden ist, ist der Pass-Gate-Transistor PGT für das Eingangssignal IN dann durchgeschaltet, wenn das Taktsignal Φ seinen aktiven Pegel aufweist (im Fall eines n-Kanal-Transistors als Pass-Gate-Transistor PGT: das Taktsignal Φ hat einen hohen Pegel). In diesem anderen Fall ist es somit möglich, den Pass-Gate-Transistor PGT dann mittels des Taktsignals Φ zu sperren, wenn der I/O-Anschluß PIO gerade als Anschluß für das Ausgangssignal OUT fungiert und den Pass-Gate-Transistor PGT dann elektrisch durchzuschalten, wenn der I/O-Anschluß PIO gerade als Anschluß für das Eingangssignal IN fungiert. Pass-Gate-Transistoren PGT sind auch vorsehbar bei solchen ersten Schutzschaltungen PADIN, die mit Anschlüssen PI verbunden sind, welche im Betrieb ausschließlich Eingangssignale IN führen.

Figur 10 zeigt eine vorteilhafte Dimensionierung des Pass-Gate-Transistors PGT: Dabei weist das Gate G von Source S und Drain D jeweils einen Abstand B auf, welcher mindestens das 1,5-fache von entsprechenden Abstandswerten beträgt von Transistoren, die die integrierte Halbleiterschaltung außerhalb der Schutzanordnung enthält (z. B. in den Schaltungsteilen CKT-I, CKT-O).

Weiterhin ist es vorteilhaft, wie in den Figuren 4 und 9 durch die beispielhaften Angaben "0.8Ω" und "2.5Ω" bzw. "1Ω" und "2Ω" kenntlich gemacht, wenn die zusätzlichen Leitungen LO1 niederohmiger sind als die das jeweilige Ausgangssignal OUT führenden Leitungen LO. Bei einer solchen Anordnung kann die jeweilige zweite Schutzschaltung PADOUT (bzw. die erste Schutzschaltung PADIN im Falle von 1/0-Anschlüssen PIO nach Figur 9) schneller auf ein eintretendes ESD-Ereignis ansprechen als ohne eine solche Maßnahme. Die das jeweilige Ausgangssignal OUT führenden Leitungen LO sollten dabei einen Widerstand von wenigstens 2Ω aufweisen, welcher gleichmäßig über den Bereich zwischen dem jeweiligen Anschluß PO (bzw. PIO) und dem zugehörigen zweiten Schaltungsteil (CKT-O) verteilt ist.

Bekanntlich ist bei jeder integrierten Halbleiterschaltung mit ersten Schaltungsteilen CKT-I und zweiten Schaltungsteilen CKT-O, die wannenförmige Bereiche gleichen Leitfähigkeitstyps aufweisen, welche im Betrieb unterschiedliche Potentiale führen, durch Spezifikation und Design-Rules festgelegt, welchen gegenseitigen Abstandswert solche wannenförmigen Bereiche im Minimum aufweisen dürfen. Bei einer erfindungsgemäßen integrierten Halbleiterschaltung ist es vorteilhaft, wenn die wannenförmigen Bereiche S-well und D-well der Feldoxidtransistoren FOX der Schutzschaltungen PADIN, PADOUT je Feldoxidtransistor FOX gegenseitige Abstände A aufweisen, die den vorgenannten minimalen Abstandswert nicht überschreiten. Dies ist in den Figuren 3 und 5 ebenfalls dargestellt anhand eines beispielhaften (Minimal-)Abstandswertes von ≤5µm. Weiterhin ist es günstig im Hinblick auf eine optimal gegen ESD-Ereignisse geschützte integrierte Halbleiterschaltung, wenn die Source- und Drain-Bereiche S, D der Feldoxidtransistoren FOX der ersten Schutzschaltungen PADIN und/oder der zweiten Schutzschaltungen PADOUT über eine Vielzahl elektrischer Kontakte mit dem jeweiligen darunterliegenden wannenförmigen Bereich S-well bzw. D-well verbunden sind. Dies kann z. B. mittels Bereichen Reg erfolgen, die eine höhere Dotierung als die entsprechenden wannenförmigen Bereiche S-well, D-well aufweisen. Figur 3 zeigt den Feldoxidtransistor FOX einer ersten Schutzschaltung PADIN mit solchen höher dotierten Bereichen Reg.

Figur 11 zeigt, wiederum stark schematisiert dargestellt, ein mögliches, vorteilhaftes Layout einer Schutzschaltung in Draufsicht. Aus Gründen der Übersichtlichkeit enthält diese Darstellung beim Feldoxidtransistor FOX lediglich Source S und Drain D, nicht jedoch das Gate des Feldoxidtransistors FOX. Die Darstellung ist gültig sowohl für eine erste Schutzschaltung PADIN wie auch für eine zweite Schutzschaltung PADOUT. Dabei ist der Feldoxidtransistor FOX als Fingertransistor ausgebildet, d. h. Source S und Drain D sind finger- oder kammförmig ausgebildet, wobei jeweils ein Sourcefinger neben einem Drainfinger zu liegen kommt und umgekehrt. Eine solche Ausbildung ist als solche bereits aus der DE-A 39 07 523 bekannt. Sie ist dort als mäanderförmig bezeichnet. In Weiterbildung dieser als solche bereits bekannten Fingertransistoren sind bei deren Ecken die Fingerspitzen, d. h. die Enden der jeweiligen Transistorfinger, abgeschrägt. Es ist auch möglich, die Fingertransistoren so auszulegen, daß sämtliche Ecken der Fingertransistoren abgeschrägt sind. Das Abschrägen kann auch in Form eines Verrundens erfolgen.

Der Diffusionswiderstand R_{dif}, welcher zwischen der Drain D der als Null-Volt-Transistor ausgelegten feldgesteuerten Diode ZVT und der Drain D des Feldoxidtransistors FOX angeordnet ist, ist dabei innerhalb der für ihn zur Verfügung stehenden Fläche großflächig ausgeführt, d. h. bei vorgegebenem Widerstandswert, mit einem bestimmten spezifischen Widerstand pro Querschnittsflächeneinheit ist er möglichst lang und breit ausgeführt, so daß sich eine möglichst große Oberfläche für den Widerstand R_{dif} ergibt. Dies erleichtert im Betrieb das Abführen von im Diffusionswiderstand R_{dif} auftretender Verlustleistung (Wärme).

Die feldgesteuerte Diode ZVT ist in Figur 11 als Null-Volt-Transistor ausgeführt, dessen Gate G knochenförmig ausgelegt ist, wobei es im Bereich zwischen Source S und Drain D des Null-Volt-Transistors eine konstante Breite aufweist, so daß auch hiermit der Eintritt eines ESD-Schadens weitestgehend ausgeschlossen ist. Das Gate G des Null-Volt-Transistors weist vorteilhafterweise Abstandswerte A auf von der Source S und von der Drain D des Null-Volt-Transistors, die wenigstens das 1,5fache der entsprechenden Abstandswerte beträgt von Transistoren, die die integrierte Halbleiterschaltung außerhalb der Schutzanordnung enthält (z. B. in den Schaltungsteilen CKT-I, CKT-O).

Nachstehend werden einige zur Vermeidung von ESD-Schäden vorteilhafte zusätzliche Maßnahmen beschrieben, welche die Potentialschienen P1, P2 für die Versorgungspotentiale VSS, VCC betreffen bwz. Leitungen für ein bei der integrierten Halbleiterschaltung ggf. vorhandenes Substratvorspannungspotential VBB. Figur 13 zeigt mehrere Dioden Dd, die zwischen den beiden Potentialschienen P1, P2 angeordnet sind in der Art, daß sie bei einem regulären Betrieb der integrierten Halbleiterschaltung sperren. Wenn nun ein ESD-Ereignis eintritt, bei dem die im Betrieb das erste Versorgungspotential VSS führende Potentialschiene P1 ein positiveres Potential erhält als es die (im Betrieb das gegenüber VSS angenommenermaßen positivere zweite Versorgungspotential VCC führende) zweite Potentialschiene P2 aufweist, so wird dieses durch das ESD-Ereignis verursachte positivere Potential über die Dioden Dd auf die zweite Potentialschiene P2 abgeleitet und somit unschädlich gemacht. Dabei ist es sinnvoll, wenn bei Vorhandensein von mehr als einer Diode Dd (wie dargestellt) diese in gegenseitigen Abständen von höchstens 10mm angeordnet sind und daß sie in regelmäßigen Abständen zueinander angeordnet sind.

Figur 14 zeigt eine der Figur 13 entsprechende Anordnung, bei der die Dioden als Feldoxidtransistor FOX-V realisiert sind, deren Gates mit der zweiten Potentialschiene P2 verbunden sind. Auch hierbei ist es günstig, daß die Feldoxidtransistoren FOX-V einen gegenseitigen Abstand von höchstens 10mm aufweisen und daß sie in regelmäßigen Abständen zueinander angeordnet sind.

Manche integrierte Halbleiterschaltungen weisen für ein und dasselbe Versorgungspotential mehrere Potentialschienen auf, die dann eine Art Potentialbus darstellen. Nachstehend sind erfindungsgemäße integrierte Halbleiterschaltungen mit Schutzanordnungen gegen Überspannungen beschrieben, die mehrere solche Potentialschienen aufweisen. In den zugehörigen Figuren sind dabei aus Gründen der Übersichtlichkeit nur die mit solchen Potentialschienen im Zusammenhang stehenden Maßnahmen dargestellt.

Figur 15 zeigt zwei erste Potentialschienen P1, bezeichnet mit P1-1 und P1-2. Sie führen im Betrieb angenommenermaßen das erste Versorgungspotential VSS der erfindungsgemäßen integrierten Halbleiterschaltung. Die Potentialschienen P1-1, P1-2 sind erfindungsgemäß mit wenigstens einem Paar von Diodeneinrichtungen D1, D2 (dargestellt sind drei Paare) miteinander verbunden, wobei die Diodeneinrichtungen D1, D2 eines jeden Paares jeweils antiparallel zueinander geschaltet sind. In Figur 15 besteht jede Diodeneinrichtung D1 bzw. D2 aus jeweils einer einzigen Diode. In Figur 16 ist dargestellt, daß jede Diodeneinrichtung D1 bzw. D2 mehr als eine Diode enthalten kann, beispielsweise zwei Dioden D1-1, D1-2 bzw. D2-1, D2-2.

Ensprechendes ist auch vorteilhaft, wenn als zweite Potentialschiene P2 (für das zweite Versorgungspotential VCC) mehrere Schienen P2-1, P2-2 vorhanden sind. Dieser Fall ist ebenfalls den Figuren 15, 16 entnehmbar über die entsprechenden, in Klammern gesetzten Bezugszeichen.

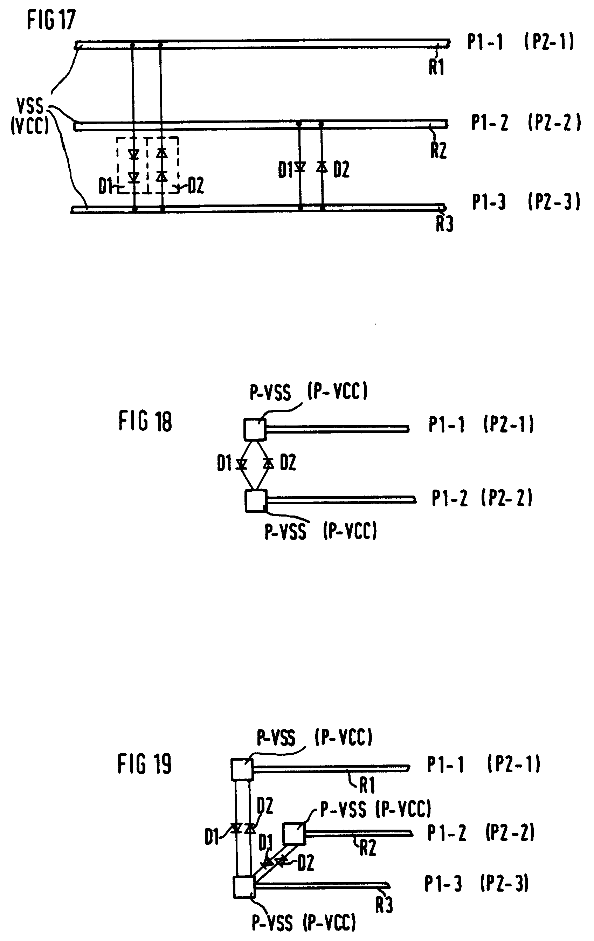

Es ist für den Fachmann sicherlich leicht einsehbar, daß mehrere Potentialschienen für ein und dasselbe Versorgungspotential (z. B. mehrere erste Potentialschienen P1-1, P1-2, P1-3 für das erste Versorgungspotential VSS) verschiedene ohm'sche Widerstände als Leiterbahnwiderstände aufweisen können (z. B. verursacht durch unterschiedliche Längen und/oder Querschnitte ihrer Leiterbahnen). Ein solcher Fall ist in Figur 17 anhand von drei ersten Potentialschienen P1-1, P1-2, P1-3 (bzw. drei zweiten Potentialschienen P2-1, P2-2, P2-3 entsprechend den in Figur 17 in Klammer gesetzten Bezugszeichen) dargestellt. Die einzelnen Leiterbahnwiderstände sind dabei mit R1, R2, R3 angedeutet mit der Annahme, daß R3 den kleinsten Wert aufweist. In einem solchen Fall ist es günstig, wenn die Potentialschienen mit den größeren Werten für die Leiterbahnwiderstände {im Beispiel also die Potentialschienen P1-1, P1-2 (bzw. P2-1, P2-2) mit den Werten R1 und R2}, sternförmig mit derjenigen Leiterbahn über die Paare von jeweils antiparallel geschalteten Diodeneinrichtungen D1, D2 verbunden sind, die den kleinsten Wert (R3) aufweist. In Figur 17 ist dies die Potentialschiene P1-3 (bzw. P2-3).

Weiterhin ist es möglich, daß die mehreren ersten Potentialschienen P1-1, P1-2 (bzw. die mehreren zweiten Potentialschienen P2-1, P2-2) jeweils eigene Potentialanschlüsse P-VSS (bzw. P-VCC) am Halbleiterchip der integrierten Halbleiterschaltung aufweisen. In solchen Fällen ist es günstig, wie in den Figuren 18 und 19 gezeigt, die vorgenannten Diodeneinrichtungen D1, D2 nicht mit den Potentialschienen P1-1, P1-2, ggf. P1-3 (bzw. P2-1, P2-2, ggf. P2-3) zu verbinden (siehe Figuren 15 bis 17), sondern mit den jeweiligen Potentialanschlüssen P-VSS (bzw. P-VCC). Figur 19 zeigt dabei einen der Figur 17 entsprechenden Fall, d. h. eine sternförmige Verbindung der Potentialanschlüsse P-VSS (bzw. P-VCC).

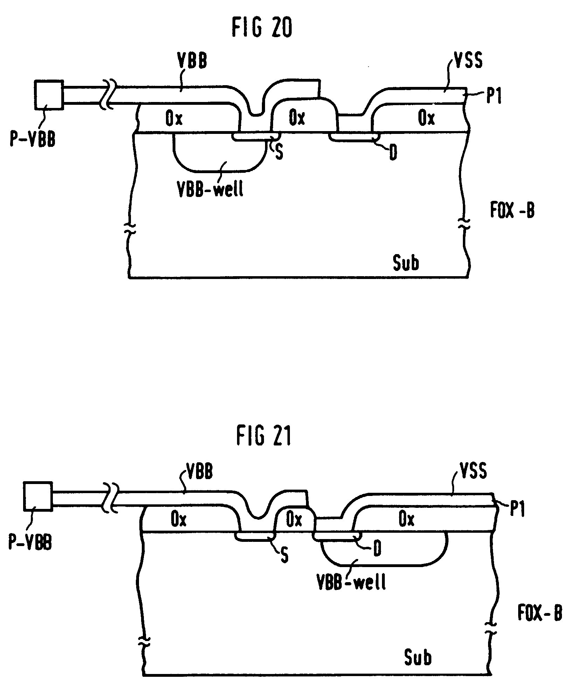

Die Figuren 20 und 21 zeigen vorteilhafte ESD-Schutzmaßnahmen für integrierte Halbleiterschaltungen, welche an ihrem Halbleiterchip einen oder mehrere Anschlüsse P-VBB aufweist für ein Substratvorspannungspotential VBB, das die Halbleiterschaltung im Betrieb führt. In der Vergangenheit wurde einem solchen am Chip befindlichen Anschluß P-VBB der integrierten Halbleiterschaltung über einen am Gehäuse befindlichen Pin das Substratvorspannungspotential VBB von extern zugeführt. Dies ist heute zwar nicht mehr üblich, da heute das Substratvorspannungspotential VBB meist chip-intern mittels Substratvorspannungsgeneratoren erzeugt wird, so daß dieser externe Anschluß entfallen könnte. Aber es ist trotzdem möglich, daß eine integrierte Halbleiterschaltung mit internem Substratvorspannungsgenerator nach wie vor einen solchen externen Anschluß aufweist, der im Betrieb das Substratvorspannungspotential VBB führt, beispielsweise zu Meß- und/oder Testzwecken. Weiterhin ist es auch möglich, daß eine solche integrierte Halbleiterschaltung zwar keinen externen Anschluß in Form eines Pins aufweist für die Substratvorspannung VBB, daß aber (beispielsweise aus Gründen, die in der beim Einbetten des Chips in ein Gehäuse verwendeten Montagetechnik liegen können) der Halbleiterchip einen solchen Anschluß P-VBB aufweist, an den eine (oder mehrere) chip-externe Leitung angeschlossen ist, welche im Gehäuse der integrierten Halbleiterschaltung geführt ist und die stumpf an der Oberfläche der integrierten Halbleiterschaltung endet (meist an der Stirnfläche bei integrierten Halbleiterschaltungen in DIL- oder DIP-Gehäusen). Dies dient beispielsweise einer mechanischen Stabilisierung der Spinne bzw. des Spinnenträgers bezüglich des Halbleiterchips während des Montagevorganges des Chips in das Gehäuse.

In allen diesen vorbeschriebenen Fällen, in denen eine elektrische Leitung von einem Anschluß P-VBB des Chips an die Oberfläche des Gehäuses der integrierten Halbleiterschaltung geführt ist oder gar durch dieses hindurch als Pin, ist es sinnvoll, diesen Anschluß P-VBB gegen ESD-Ereignisse zu schützen, da ESD-Ereignisse mittels dieser Leitung auf den Anschluß P-VBB und somit auf die integrierte Schaltung einwirken können.

Figur 20 zeigt eine vorteilhafte Ausführungsform eines solchen Schutzes. Dabei ist zwischen dem Anschluß P-VBB für das Substratvorspannungspotential VBB und der ersten Potentialschiene P1 ein Feldoxidtransistor FOX-B angeordnet, dessen Gate mit dem Anschluß P-VBB verbunden ist. Der Feldoxidtransistor FOX-B weist unterhalb seines Source-Bereiches S einen weiteren wannenförmigen Bereich VBB-well auf.

Eine weitere Ausführungsform ist in Figur 21 gezeigt. Sie unterscheidet sich von der Ausführungsform nach Figur 20 nur insoweit, als der weitere wannenförmige Bereich VBB-well unterhalb des Drain-Bereiches D des Feldoxidtransistors FOX-B angeordnet ist und nicht unterhalb des Source-Bereiches S.

## Patentansprüche

1. Integrierte Halbleiterschaltung mit einem Halbleitersubstrat (Sub),
- mit wenigstens einer ersten Potentialschiene (P1), die im Betrieb ein erstes Versorgungspotential (VSS) der Halbleiterschaltung führt,
- mit wenigstens einer zweiten Potentialschiene (P2), die im Betrieb ein zweites Versorgungspotential (VCC) der Halbleiterschaltung führt,
- mit wenigstens einem ersten Schaltungsteil (CKT-I) zum Empfang und zur Verarbeitung von Eingangssignalen (IN)
- mit wenigstens einem zweiten Schaltungsteil (CKT-O), in dem im Betrieb der Halbleiterschaltung wenigstens ein Ausgangssignal (OUT) der Halbleiterschaltung entsteht, und
- mit einer Schutzanordnung gegen Überspannungen, welche bei jedem Anschluß (PI) für eine eines der Eingangssignale (IN) führende Leitung (LI) eine erste Schutzschaltung (PADIN) enthält, welche zwischen dem jeweiligen Anschluß (PI) und einem jeweiligen ersten Schaltungsteil (CKT-I) angeordnet ist und welche folgende Merkmale aufweist:
- zwischen der das Eingangssignal (IN) führenden Leitung (LI) und der ersten Potentialschiene (P1) sind elektrisch parallel zueinander ein Feldoxidtransistor (FOX) und eine feldgesteuerte Diode (ZVT) angeordnet, wobei das Gate des Feldoxidtransistors (FOX) mit der Leitung (LI) verbunden ist, wobei die Feldsteuerung der Diode (ZVT) über die erste Potentialschiene (P1) erfolgt, und wobei der Feldoxidtransistor (FOX) und die feldgesteuerte Diode (ZVT) an verschiedenen Punkten (x, y) der das Eingangssignal (IN) führenden Leitung (LI) mit dieser elektrisch verbunden sind,
- die das Eingangssignal (IN) führende Leitung (LI) enthält zwischen den beiden Punkten (x, y) einen Diffusionswiderstand (R_{dif}),
- beim Feldoxidtransistor (FOX) sind unterhalb des Source-Bereiches (S) und unterhalb des Drain-Bereiches (D) jeweils ein wannenförmiger Bereich (S-well, D-well) ausgebildet im Abstand zueinander, die beide vom selben Leitungstyp sind wie der Source- und der Drain-Bereich (S, D),
**dadurch gekennzeichnet**, daß die Schutzanordnung folgende weitere Merkmale enthält:
- bei jedem Anschluß (PO) für eine ein jeweiliges Ausgangssignal (OUT) führende Leitung (LO) ist über eine zusätzliche Leitung (LO1) eine zweite Schutzschaltung (PADOUT) angeschlossen, welche ebenfalls einen Feldoxidtransistor (FOX), eine feldgesteuerte Diode (ZVT) und einen Diffusionswiderstand (R_{dif}) enthält, die bezüglich der zusätzlichen Leitung (LO1) und der ersten Potentialschiene (P1) genauso angeordnet sind wie Feldoxidtransistor (FOX), feldgesteuerte Diode (ZVT) und Diffusionswiderstand (R_{dif}) einer der ersten Schutzschaltungen (PADIN) hinsichtlich der betreffenden das Eingangssignal (IN) führenden Leitung (LI) und der ersten Potentialschiene (P1) und die ebenfalls entsprechende wannenförmige Bereiche (S-well, D-well) aufweist wie eine der ersten Schutzschaltungen (PADIN)
- wenigstens eine der Potentialschienen (P1; P2) ist in Bereichen, in denen ihr wenigstens eine der Schutzschaltungen (PADIN, PADOUT) benachbart ist, mit einer im Substrat (Sub) wannenförmig ausgebildeten Schutzstruktur (VSS-well; VCC-well) unterlegt, welche mit der jeweiligen Potentialschiene (P1; P2) elektrisch leitend verbunden ist.

2. Integrierte Halbleiterschaltung nach Anspruch 1, **dadurch gekennzeichnet**, daß zwischen der Schutzstruktur (VSS-well; VCC-well) und der entsprechenden Potentialschiene (P1; P2) ein Bereich (Reg) angeordnet ist, welcher eine gegenüber der Schutzstruktur (VSS-well; VCC-well) erhöhte Dotierung aufweist.

3. Integrierte Halbleiterschaltung nach Anspruch 1 oder 2, **dadurch gekennzeichnet**, daß wenigstens eine der Schutzstrukturen (VSS-well, VCC-well) bis an den jeweiligen Anschluß (PI,PO) heranreicht.

4. Integrierte Halbleiterschaltung nach einem der Ansprüche 1, 2 oder 3,
**dadurch gekennzeichnet**, daß die Schutzstrukturen (VSS-well, VCC-well) mindestens 5µm breit sind.

5. Integrierte Halbleiterschaltung nach einem der Ansprüche 1, 2 oder 3,
**dadurch gekennzeichnet**, daß die Breite einer Schutzstruktur (VSS-well; VCC-well) wenigstens 10% der Breite der darüberliegenden Potentialschiene (P1; P2) beträgt.

6. Integrierte Halbleiterschaltung nach einem der vorhergehenden Ansprüche, **dadurch gekennzeichnet**, daß wenigstens eine der Schutzstrukturen (VSS-well; VCC-well) von einem Leitungstyp ist, der entgegengesetzt ist zum Leitungstyp des Halbleitersubstrates (Sub).

7. Integrierte Halbleiterschaltung nach einem der vorhergehenden Ansprüche, **dadurch gekennzeichnet**, daß wenigstens eine der Schutzstrukturen (VSS-well; VCC-well) vom selben Leitungstyp ist wie der Leitungstyp des Halbleitersubstrates (Sub).

8. Integrierte Halbleiterschaltung nach einem der vorhergehenden Ansprüche, **dadurch gekennzeichnet**, daß das Halbleitersubstrat (Sub) auf einer Epi-Schicht (Epi) angeordnet ist.

9. Integrierte Halbleiterschaltung nach einem der vorhergehenden Ansprüche, **dadurch gekennzeichnet,**
daß ein Anschluß (PI) für eine ein Eingangssignal (IN) führende Leitung (LI) und ein Anschluß (PO) für eine ein Ausgangssignal (OUT) führende Leitung (LO) zusammenfallen und dabei einen gemeinsamen physikalischen Anschluß (PIO) bilden, über den sowohl das Eingangssignal (IN) wie auch das Ausgangssignal (OUT) führbar sind und
daß eine erste Schutzschaltung (PADIN) für das Eingangssignal (IN) gleichzeitig eine Schutzschaltung (PADOUT) für das Ausgangssignal (OUT) ist.

10. Integrierte Halbleiterschaltung nach einem der vorhergehenden Ansprüche, **dadurch gekennzeichnet**,
daß die zusätzlichen Leitungen (LO1) niederohmiger sind als die das jeweilige Ausgangssignal (OUT) führende Leitung (LO).

11. Integrierte Halbleiterschaltung nach Anspruch 10, **dadurch gekennzeichnet**, daß die ein jeweiliges Ausgangssignal (OUT) führenden Leitungen (LO) einen Widerstand von wenigstens 2 Ohm aufweisen.

12. Integrierte Halbleiterschaltung nach Anspruch 10 oder 11, **dadurch gekennzeichnet**, daß der Widerstand einer jeweiligen ein Ausgangssignal (OUT) führenden Leitung (LO) gleichmäßig über den Bereich zwischen dem Anschluß (PO; PIO) und dem jeweiligen zweiten Schaltungsteil (CKT-O) verteilt ist.

13. Integrierte Halbleiterschaltung nach einem der vorhergehenden Ansprüche, **dadurch gekennzeichnet**, daß die wannenförmigen Bereiche (S-well, D-well) unterhalb des Feldoxidtransistors (FOX) einer jeweiligen Schutzschaltung (PADIN; PADOUT) einen gegenseitigen Abstand (A) aufweisen, der höchstens gleich ist demjenigen Abstandswert, den außerhalb der Schutzanordnung der Halbleiterschaltung auftretende sonstige wannenförmige, unterschiedliche Potentiale aufweisende Bereiche vom selben Leitfähigkeitstyp wie die wannenförmigen Bereiche (S-well, D-well) des Feldoxidtransistors (FOX) im Minimum als entsprechende Abstandswerte aufweisen.

14. Integrierte Halbleiterschaltung nach einem der vorhergehenden Ansprüche, **dadurch gekennzeichnet**, daß die Source- und Drain-Bereiche (S, D) der Feldoxidtransistoren (FOX) der ersten Schutzschaltungen (PADIN) über eine Vielzahl von Kontakten mit dem jeweiligen darunterliegenden wannenförmigen Bereich (S-well; D-well) elektrisch verbunden sind.

15. Integrierte Halbleiterschaltung nach Anspruch 14, **dadurch gekennzeichnet**, daß die wannenförmigen Bereiche (S-well; D-well) der ersten Schutzschaltungen (PADIN) zusätzlich einen Bereich höherer Dotierung (Reg) aufweisen, über den die Kontaktierung mit den Source- und Drain-Bereichen (S, D) der Feldoxidtransistoren (FOX) erfolgt.

16. Integrierte Halbleiterschaltung nach einem der vorhergehenden Ansprüche, **dadurch gekennzeichnet**, daß die Source- und Drain-Bereiche (S, D) der Feldoxidtransistoren (FOX) der zweiten Schutzschaltungen (PADOUT) über eine Vielzahl von Kontakten mit dem jeweiligen darunterliegenden wannenförmigen Bereich (S-well; D-well) elektrisch verbunden sind.

17. Integrierte Halbleiterschaltung nach Anspruch 16, **dadurch gekennzeichnet**, daß die wannenförmigen Bereiche (S-well; D-well) der zweiten Schutzschaltungen (PADOUT) zusätzlich einen Bereich höherer Dotierung (Reg) aufweisen, über den die Kontaktierung mit den Source- und Drain-Bereichen (S, D) der Feldoxidtransistoren (FOX) erfolgt.

18. Integrierte Halbleiterschaltung nach einem der vorhergehenden Ansprüche, **dadurch gekennzeichnet**, daß die Feldoxidtransistoren (FOX) der ersten Schutzschaltungen (PADIN) als Fingertransistoren ausgebildet sind.

19. Integrierte Halbleiterschaltung nach einem der vorhergehenden Ansprüche, **dadurch gekennzeichnet**, daß die Feldoxidtransistoren (FOX) der zweiten Schutzschaltungen (PADOUT) als Fingertransistoren ausgebildet sind.

20. Integrierte Halbleiterschaltung nach Anspruch 18 oder 19, **dadurch gekennzeichnet**, daß bei den Ecken der Fingertransistoren mindestens die Fingerspitzen abgeschrägt sind.

21. Integrierte Halbleiterschaltung nach einem der vorhergehenden Ansprüche, **dadurch gekennzeichnet**, daß die Diffusionswiderstände (R_{dif}) großflächig ausgeführt ist.

22. Integrierte Halbleiterschaltung nach einem der vorhergehenden Ansprüche, **dadurch gekennzeichnet**, daß die Schutzschaltungen (PADIN, PADOUT) in unmittelbarer Nähe des jeweiligen Anschlusses (PI, PO, PIO) angeordnet sind.

23. Integrierte Halbleiterschaltung nach einem der vorhergehenden Ansprüche, **dadurch gekennzeichnet**, daß die feldgesteuerte Diode (ZVT) als Null-Volt-Transistor realisiert ist.

24. Integrierte Halbleiterschaltung nach Anspruch 23, **dadurch gekennzeichnet**, daß das Gate (G) des Null-Volt-Transistors (ZVT) knochenförmig ausgelegt ist.

25. Integrierte Halbleiterschaltung nach Anspruch 23 oder 24, **dadurch gekennzeichnet**, daß bei einem Null-Volt-Transistor (ZVT) das Gate einen Abstand (A) aufweist von der jeweiligen Source und von der jeweiligen Drain, der wenigstens das 1,5-fache desjenigen Abstandswertes beträgt, den außerhalb der Schutzanordnung in der Halbleiterschaltung enthaltene Transistoren im Minimum als entsprechende Abstandswerte aufweisen.

26. Integrierte Halbleiterschaltung nach einem der vorhergehenden Ansprüche, **dadurch gekennzeichnet**, daß einer ersten Schutzschaltung (PADIN) wenigstens ein Pass-Gate-Transistor (PGT) nachgeschaltet ist.

27. Integrierte Halbleiterschaltung nach Anspruch 26, **dadurch gekennzeichnet**, daß das Gate des Pass-Gate-Transistors (PGT) mit dem zweiten Versorgungspotential (VCC) verbunden ist.

28. Integrierte Halbleiterschaltung nach Anspruch 26, **dadurch gekennzeichnet**, daß der Pass-Gate-Transistor (PGT) mittels seines Gates schaltbar (Φ) ist.

29. Integrierte Halbleiterschaltung nach einem der Ansprüche 26 bis 28, **dadurch gekennzeichnet**, daß das Gate des Pass-Gate-Transistors (PGT) einen Abstand (B) aufweist von seiner Source und von seiner Drain, der wenigstens das 1,5-fache desjenigen Abstandswertes beträgt, den außerhalb der Schutzanordnung in der Halbleiterschaltung enthaltene Transistoren im Minimum als entsprechende Abstandswerte aufweisen.

30. Integrierte Halbleiterschaltung nach einem der Ansprüche 1 bis 29, **dadurch gekennzeichnet**, daß der Source-Bereich (S) des Feldoxidtransistors (FOX) wenigstens einer der Schutzschaltungen (PADIN, PADOUT) über eine Molybdän-Silizid-Schicht (MoSi) mit der ersten Potentialschiene (P1) verbunden ist.

31. Integrierte Halbleiterschaltung nach einem der Ansprüche 1 bis 29, **dadurch gekennzeichnet**, daß der Source-Bereich (S) des Feldoxidtransistors (FOX) wenigstens einer der Schutzschaltungen (PADIN, PADOUT) mit der ersten Potentialschiene (P1) verbunden ist unter Verwendung eines Widerstandes (R), dessen Wert mindestens das 5-fache des Wertes beträgt, der sich ergäbe, wenn die Verbindung ohne den Widerstand (R) ausgeführt wäre.

32. Integrierte Halbleiterschaltung nach einem der Ansprüche 1 bis 31, **dadurch gekennzeichnet**, daß der Drain-Bereich (D) des Feldoxidtransistors (FOX) wenigstens einer der Schutzschaltungen (PADIN, PADOUT) über eine Molybdän-Silizium-Schicht (MoSi) mit der das jeweilige Signal (IN; OUT) führenden Leitung (LI; L01)verbunden ist.

33. Integrierte Halbleiterschaltung nach einem der Ansprüche 1 bis 31, **dadurch gekennzeichnet**, daß der Drain-Bereich (D) des Feldoxidtransistors (FOX) wenigstens einer der Schutzschaltungen (PADIN, PADOUT) mit der das jeweilige Signal (IN; OUT) führenden Leitung (LI; L01) verbunden ist unter Verwendung eines Widerstandes (R), dessen Wert mindestens das 5-fache des Wertes beträgt, der sich ergäbe, wenn die Verbindung ohne den Widerstand (R) ausgeführt wäre.

34. Integrierte Halbleiterschaltung nach einem der vorhergehenden Ansprüche, **dadurch gekennzeichnet**, daß zwischen den beiden Potentialschienen (P1, P2) wenigstens eine Diode (Dd) angeordnet ist in einer Art, daß sie bei üblichem Betrieb der Halbleiterschaltung sperrt.

35. Integrierte Halbleiterschaltung nach Anspruch 34, **dadurch gekennzeichnet**, daß mehr als eine Diode (Dd) angeordnet sind und daß sie in gegenseitigen Abständen von maximal 10mm angeordnet sind.

36. Integrierte Halbleiterschaltung nach Anspruch 35, **dadurch gekennzeichnet**, daß die Dioden (Dd) in regelmäßigen Abständen angeordnet sind.

37. Integrierte Halbleiterschaltung nach einem der vorhergehenden Ansprüche, **dadurch gekennzeichnet**, daß zwischen den beiden Potentialschienen (P1, P2) wenigstens ein Feldoxidtransistor (FOX-V) angeordnet ist, dessen Gate mit der zweiten Potentialschiene (VCC) verbunden ist.

38. Integrierte Halbleiterschaltung nach Anspruch 37, **dadurch gekennzeichnet**, daß mehrere Feldoxidtransistoren (FOX-V) in gegenseitigen Abständen von maximal 10mm angeordnet sind.

39. Integrierte Halbleiterschaltung nach Anspruch 38, **dadurch gekennzeichnet**, daß die Feldoxidtransistoren (FOX-V) in regelmäßigen Abständen angeordnet sind.

40. Integrierte Halbleiterschaltung nach einem der vorhergehenden Ansprüche, **dadurch gekennzeichnet**, daß bei Vorhandensein mehrerer, im Betrieb dasselbe Versorungspotential (VSS; VCC) führender Potentialschienen (P1-1, P1-2; P2-1, P2-2) diese Potentialschienen (P1-1, P1-2; P2-1, P2-2) über wenigstens ein Paar von zwei antiparallel geschalteten Diodeneinrichtungen (D1, D2) miteinander verbunden sind.

41. Integrierte Halbleiterschaltung nach Anspruch 40, **dadurch gekennzeichnet**, daß eine Diodeneinrichtung (D1, D2) eine oder mehrere in Serie zueinander geschaltete Dioden (D1-1, D1-2; D2-1, D2-2) aufweist.

42. Integrierte Halbleiterschaltung nach Anspruch 40 oder 41, **dadurch gekennzeichnet**, daß die Paare von Diodeneinrichtungen (D1, D2) sternförmig mit derjenigen Potentialschiene (P1; P2) verbunden sind, welche den geringsten ohm'schen Widerstand (R3) aufweist.

43. Integrierte Halbleiterschaltung nach einem der Ansprüche 40 bis 42, **dadurch gekennzeichnet**, daß in einem Fall, in dem die mehreren, im Betrieb dasselbe Versorgungspotential (VSS; VCC) führenden Potentialschienen (P1-1, P1-2; P2-1, P2-2) jeweils einen eigenen Potentialanschluß (P-VSS; P-VCC) aufweisen, die Paare von Diodeneinrichtungen (D1, D2) mit den jeweiligen Potentialanschlüssen (P-VSS; P-VCC) verbunden sind.

44. Integrierte Halbleiterschaltung nach Anspruch 43, **dadurch gekennzeichnet,** daß die Paare von Diodeneinrichtungen (D1, D2) sternförmig mit demjenigen Potentialanschluß (P-VSS, P-VCC) der dasselbe Potential aufweisenden Potentialschienen (P1-1, P1-2, P1-3; P2-1, P2-2, P2-3) verbunden sind, dessen angeschlossene Potentialschiene (P1; P2) den geringsten ohm'schen Widerstand (R3) aufweist.

45. Integrierte Halbleiterschaltung nach einem der vorhergehenden Ansprüche, **dadurch gekennzeichnet**, daß die Halbleiterschaltung wenigstens einen Anschluß (P-VBB) aufweist, welcher im Betrieb der Halbleiterschaltung ein Substratvorspannungspotential (VBB) führt, daß zwischen diesem Anschluß (P-VBB) und der ersten Potentialschiene (P1) ein Feldoxidtransistor (FOX-B) angeordnet ist, dessen Gate mit diesem Anschluß (P-VBB) verbunden ist und daß beim Feldoxidtransistor (FOX-B) entweder wenigstens teilweise unterhalb des Drain-Bereiches (D) oder wenigstens teilweise unterhalb des Source-Bereiches (S) ein weiterer wannenförmiger Bereich (VBB-well) ausgebildet ist.

## Claims

1. Integrated semiconductor circuit having a semiconductor substrate (Sub),
- having at least one first busbar (P1), which carries a first supply potential (VSS) of the semiconductor circuit during operation,
- having at least one second busbar (P2), which carries a second supply potential (VCC) of the semiconductor circuit during operation,
- having at least one first circuit section (CKT-I) for receiving and processing input signals (IN),
- having at least one second circuit section (CKT-O), in which at least one output signal (OUT) of the semiconductor circuit is produced during operation of the semiconductor circuit, and
- having a protective arrangement against overvoltages, which contains a first protective circuit (PADIN) for each terminal (PI) for a line (LI) carrying one of the input signals (IN), which protective circuit is arranged between the respective terminal (PI) and a respective first circuit section (CKT-I) and which has the following features:
- a field oxide transistor (FOX) and a field-controlled diode (ZVT) are arranged electrically in parallel with one another between the line (LI) which carries the input signal (IN) and the first busbar (P1), the gate of the field oxide transistor (FOX) being connected to the line (LI), the field control of the diode (ZVT) being carried out via the first busbar (P1), and the field oxide transistor (FOX) and the field-controlled diode (ZVT) being electrically connected to the line (LI) which carries the input signal (IN) at different points (x, y) of the said line,
- the line (LI) which carries the input signal (IN) contains a diffusion resistor (R_{dif}) between the two points (x, y),
- in the case of the field oxide transistor (FOX), a respective well region (S-well, D-well) is formed below the source region (S) and below the drain region (D), the said well regions being formed at a distance from one another and both being of the same conduction type as the source and the drain region (S, D),
characterized in that the protective arrangement contains the following further features:
- for each terminal (PO) for a line (LO) which carries a respective output signal (OUT), there is connected, by means of an additional line (LO1), a second protective circuit (PADOUT), which likewise contains a field oxide transistor (FOX), a field-controlled diode (ZVT) and a diffusion resistor (R_{dif}) which are arranged with regard to the additional line (LO1) and the first busbar (P1) in exactly the same way as the field oxide transistor (FOX), field-controlled diode (ZVT) and diffusion resistor (R_{dif}) of one of the first protective circuits (PADIN) are arranged with regard to the relevant line (LI) which carries the input signal (IN) and the first busbar (P1), and which likewise has corresponding well regions (S-well, D-well) like one of the first protective circuits (PADIN),
- at least one of the busbars (P1; P2), in regions where at least one of the protective circuits (PADIN, PADOUT) is adjacent to it, has a protective structure (VSS-well; VCC-well) laid under it, which protective structure is formed as a well in the substrate (Sub) and is electrically conductively connected to the respective busbar (P1; P2).

2. Integrated semiconductor circuit according to Claim 1, characterized in that a region (Reg) which has a higher doping than the protective structure (VSS-well; VCC-well) is arranged between the protective structure (VSS-well; VCC-well) and the corresponding busbar (P1; P2).

3. Integrated semiconductor circuit according to Claim 1 or 2, characterized in that at least one of the protective structures (VSS-well, VCC-well) reaches up to the respective terminal (PI, PO).

4. Integrated semiconductor circuit according to one of Claims 1, 2 or 3, characterized in that the protective structures (VSS-well, VCC-well) have a width of at least 5 µm.

5. Integrated semiconductor circuit according to one of Claims 1, 2 or 3, characterized in that the width of a protective structure (VSS-well; VCC-well) amounts to at least 10% of the width of the superior busbar (P1; P2).

6. Integrated semiconductor circuit according to one of the preceding claims, characterized in that at least one of the protective structures (VSS-well; VCC-well) is of a conduction type which is opposite to the conduction type of the semiconductor substrate (Sub).

7. Integrated semiconductor circuit according to one of the preceding claims, characterized in that at least one of the protective structures (VSS-well; VCC-well) is of the same conduction type as the conduction type of the semiconductor substrate (Sub).

8. Integrated semiconductor circuit according to one of the preceding claims, characterized in that the semiconductor substrate (Sub) is arranged on an epitaxial layer (Epi).

9. Integrated semiconductor circuit according to one of the preceding claims, characterized
in that a terminal (PI) for a line (LI) carrying an input signal (IN) and a terminal (PO) for a line (LO) carrying an output signal (OUT) coincide and, in the process, form a common physical terminal (PIO) via which both the input signal (IN) and the output signal (OUT) can be passed, and
in that a first protective circuit (PADIN) for the input signal (IN) is simultaneously a protective circuit (PADOUT) for the output signal (OUT).

10. Integrated semiconductor circuit according to one of the preceding claims, characterized in that the additional lines (LO1) have a lower resistance than the line (LO) carrying the respective output signal (OUT).

11. Integrated semiconductor circuit according to Claim 10, characterized in that the lines (LO) carrying a respective output signal (OUT) have a resistance of at least two ohms.

12. Integrated semiconductor circuit according to Claim 10 or 11, characterized in that the resistance of a respective line (LO) carrying an output signal (OUT) is distributed uniformly over the region between the terminal (PO; PIO) and the respective second circuit section (CKT-O).

13. Integrated semiconductor circuit according to one of the preceding claims, characterized in that the well regions (S-well, D-well) below the field oxide transistor (FOX) of a respective protective circuit (PADIN; PADOUT) have a mutual distance (A) which is at most equal to that distance value which other well regions occurring outside the protective arrangement of the semiconductor circuit, having different potentials and being of the same conductivity type as the well regions (S-well; D-well) of the field oxide transistor (FOX) have, as a minimum, as corresponding distance values.

14. Integrated semiconductor circuit according to one of the preceding claims, characterized in that the source and drain regions (S, D) of the field oxide transistors (FOX) of the first protective circuits (PADIN) are electrically connected via a multiplicity of contacts to the respective inferior well region (S-well; D-well).

15. Integrated semiconductor circuit according to Claim 14, characterized in that the well regions (S-well; D-well) of the first protective circuits (PADIN) additionally have a region of higher doping (Reg), via which contact is made with the source and drain regions (S, D) of the field oxide transistors (FOX).

16. Integrated semiconductor circuit according to one of the preceding claims, characterized in that the source and drain regions (S, D) of the field oxide transistors (FOX) of the second protective circuits (PADOUT) are electrically connected via a multiplicity of contacts to the respective inferior well region (S-well; D-well).

17. Integrated semiconductor circuit according to Claim 16, characterized in that the well regions (S-well; D-well) of the second protective circuits (PADOUT) additionally have a region of higher doping (Reg), via which contact is made with the source and drain regions (S, D) of the field oxide transistors (FOX).

18. Integrated semiconductor circuit according to one of the preceding claims, characterized in that the field oxide transistors (FOX) of the first protective circuits (PADIN) are designed as finger transistors.

19. Integrated semiconductor circuit according to one of the preceding claims, characterized in that the field oxide transistors (FOX) of the second protective circuits (PADOUT) are designed as finger transistors.

20. Integrated semiconductor circuit according to Claim 18 or 19, characterized in that at least the finger tips are bevelled at the corners of the finger transistors.

21. Integrated semiconductor circuit according to one of the preceding claims, characterized in that the diffusion resistors (R_{dif}) are of large-area design.

22. Integrated semiconductor circuit according to one of the preceding claims, characterized in that the protective circuits (PADIN, PADOUT) are arranged in the immediate vicinity of the respective terminal (PI, PO, PIO).

23. Integrated semiconductor circuit according to one of the preceding claims, characterized in that the field-controlled diode (ZVT) is realized as a zero-voltage transistor.

24. Integrated semiconductor circuit according to Claim 23, characterized in that the gate (G) of the zero-voltage transistor (ZVT) is designed in the shape of a bone.

25. Integrated semiconductor circuit according to Claim 23 or 24, characterized in that in the case of a zero-voltage transistor (ZVT), the gate has a distance (A) from the respective source and from the respective drain which amounts to at least 1.5 times that distance value which transistors contained in the semiconductor circuit outside the protective arrangement have, as a minimum, as corresponding distance values.

26. Integrated semiconductor circuit according to one of the preceding claims, characterized in that at least one pass gate transistor (PGT) is connected downstream of a first protective circuit (PADIN).

27. Integrated semiconductor circuit according to Claim 26, characterized in that the gate of the pass gate transistor (PGT) is connected to the second supply potential (VCC).

28. Integrated semiconductor circuit according to Claim 26, characterized in that the pass gate transistor (PGT) can be switched (Φ) by means of its gate.

29. Integrated semiconductor circuit according to one of Claims 26 to 28, characterized in that the gate of the pass gate transistor (PGT) has a distance (B) from its source and from its drain which amounts to at least 1.5 times that distance value which transistors contained in the semiconductor circuit outside the protective arrangement have, as a minimum, as corresponding distance values.

30. Integrated semiconductor circuit according to one of Claims 1 to 29, characterized in that the source region (S) of the field oxide transistor (FOX) of at least one of the protective circuits (PADIN, PADOUT) is connected to the first busbar (P1) via a molybdenum silicide layer (MoSi).

31. Integrated semiconductor circuit according to one of Claims 1 to 29, characterized in that the source region (S) of the field oxide transistor (FOX) of at least one of the protective circuits (PADIN, PADOUT) is connected to the first busbar (P1) using a resistor (R) whose value amounts to at least 5 times the value which would be produced if the connection were implemented without the resistor (R).

32. Integrated semiconductor circuit according to one of Claims 1 to 31, characterized in that the drain region (D) of the field oxide transistor (FOX) of at least one of the protective circuits (PADIN, PADOUT) is connected via a molybdenum silicide layer (MoSi) to the line (LI; L01) carrying the respective signal (IN; OUT).

33. Integrated semiconductor circuit according to one of Claims 1 to 31, characterized in that the drain region (D) of the field oxide transistor (FOX) of at least one of the protective circuits (PADIN, PADOUT) is connected to the line (LI; L01) carrying the respective signal (IN; OUT) using a resistor (R) whose value amounts to at least 5 times the value which would be produced if the connection were implemented without the resistor (R).

34. Integrated semiconductor circuit according to one of the preceding claims, characterized in that at least one diode (Dd) is arranged between the two busbars (P1, P2), in such a way that it is switched off during normal operation of the semiconductor circuit.

35. Integrated semiconductor circuit according to Claim 34, characterized in that more than one diode (Dd) are arranged, and in that they are arranged at mutual distances of at most 10 mm.

36. Integrated semiconductor circuit according to Claim 35, characterized in that the diodes (Dd) are arranged at regular distances.

37. Integrated semiconductor circuit according to one of the preceding claims, characterized in that at least one field oxide transistor (FOX-V), whose gate is connected to the second busbar (VCC), is arranged between the two busbars (P1, P2).

38. Integrated semiconductor circuit according to Claim 37, characterized in that a plurality of field oxide transistors (FOX-V) are arranged at mutual distances of at most 10 mm.

39. Integrated semiconductor circuit according to Claim 38, characterized in that the field oxide transistors (FOX-V) are arranged at regular distances.

40. Integrated semiconductor circuit according to one of the preceding claims, characterized in that when a plurality of busbars (P1-1, P1-2; P2-1, P2-2) carrying the same supply potential (VSS; VCC) during operation-are present, these busbars (P1-1, P1-2; P2-1, P2-2) are connected to one another via at least one pair of two diode devices (D1, D2) which are reverse-connected in parallel.

41. Integrated semiconductor circuit according to Claim 40, characterized in that a diode device (D1, D2) has one or a plurality of series-connected diodes (D1-1, D1-2, D2-1, D2-2).

42. Integrated semiconductor circuit according to Claim 40 or 41, characterized in that the pairs of diode devices (D1, D2) are star-connected to that busbar (P1; P2) which has the lowest resistance (R3).

43. Integrated semiconductor circuit according to one of Claims 40 to 42, characterized in that in a case in which the plurality of busbars (P1-1, P1-2; P2-1, P2-2) carrying the same supply potential (VSS; VCC) during operation each have a dedicated potential terminal (P-VSS; P-VCC), the pairs of diode devices (D1, D2) are connected to the respective potential terminals (P-VSS; P-VCC).

44. Integrated semiconductor circuit according to Claim 43, characterized in that the pairs of diode devices (D1, D2) are star-connected to that potential terminal (P-VSS, P-VCC) of the busbars (P1-1, P1-2, P1-3; P2-1, P2-2, P2-3) having the same potential whose connected busbar (P1; P2) has the lowest resistance (R3).

45. Integrated semiconductor circuit according to one of the preceding claims, characterized in that the semiconductor circuit has at least one terminal (P-VBB) which carries a substrate bias voltage potential (VBB) during operation of the semiconductor circuit, in that a field oxide transistor (FOX-B), whose gate is connected to this terminal (P-VBB), is arranged between this terminal (P-VBB) and the first busbar (P1), and in that in the case of the field oxide transistor (FOX-B), a further well region (VBB-well) is formed either at least partially below the drain region (D) or at least partially below the source region (S).

## Revendications

1. Circuit intégré à semi-conducteurs, comportant un substrat semi-conducteur (Sub) et
- au moins une première barre de potentiel (P1) à laquelle s'applique, lors du fonctionnement, un premier potentiel d'alimentation (VSS) du circuit à semi-conducteurs,
- au moins une seconde barre de potentiel (P2) à laquelle s'applique, lors du fonctionnement, un second potentiel d'alimentation (VCC) du circuit à semi-conducteurs,
- au moins une première partie de circuit (CKT-I) destinée à la réception et au traitement de signaux d'entrée (IN),
- au moins une seconde partie de circuit (CKT-O) dans laquelle, lors du fonctionnement du circuit à semi-conducteurs, au moins un signal de sortie (OUT) du circuit à semi-conducteurs est formé, et
- un dispositif de protection contre des surtensions, dispositif qui comporte, à chaque borne (PI) destinée à un conducteur (LI) amenant un des signaux d'entrée (IN), un premier circuit de protection (PADIN), qui est prévu entre la borne (PI) considérée et une première partie de circuit (CKT-I) correspondante et qui a les caractéristiques suivantes :
- un transistor à oxyde de champ (FOX) et une diode commandée par champ (ZVT) sont montés, électriquement en parallèle, entre le conducteur (LI) amenant le signal d'entrée (IN) et la première barre de potentiel (P1), la grille du transistor à oxyde de champ (FOX) étant reliée au conducteur (LI), la commande par champ de la diode (ZVT) s'effectuant par l'intermédiaire de la première barre de potentiel (P1), et le transistor à oxyde de champ (FOX) et la diode commandée par champ (ZVT) étant reliés électriquement au conducteur (LI) amenant le signal d'entrée (IN) en différents points (x, y) de ce conducteur (LI),
- le conducteur (LI) amenant le signal d'entrée (IN) comprend entre les deux points (x, y) une résistance à diffusion (Rdif),
- pour chaque transistor à oxyde de champ (FOX), il est prévu respectivement, en dessous de la zone de source (S) et en dessous de la zone de drain (D), une zone en forme de cuvette (S-well) et une zone en forme de cuvette (D-well) qui sont à distance l'une de l'autre et qui sont du même type de conductivité que la zone de source (S) et que la zone de drain (D),
**caractérisé par le fait que** le dispositif de protection comporte les autres caractéristiques suivantes :
- à chaque borne (PO) destinée à un conducteur (LO) pour un signal de sortie (OUT), il est raccordé par l'intermédiaire d'un conducteur supplémentaire (LO1) un second circuit de protection (PADOUT) qui comporte également un transistor à oxyde de champ (FOX), une diode commandée par champ (ZVT) et une résistance à diffusion (Rdif) qui sont disposés par rapport au conducteur supplémentaire (LO1) et à la première barre de potentiel (P1) exactement comme le transistor à oxyde de champ (FOX), la diode commandée par champ (ZVT) et la résistance à diffusion (Rdif) d'un des premiers circuits de protection (PADIN) par rapport au conducteur (LI) amenant le signal d'entrée (IN) et à la première barre de potentiel (P1), et qui comporte également des zones en forme de cuvettes (S-well, D-well) comme un des premiers circuits de protection (PADIN),
- au moins l'une des barres de potentiel (P1 ; P2) se trouve en dessous de zones dans lesquelles au moins l'un des circuits de protection (PADIN, PADOUT) lui est adjacent, par une structure de protection (VSS-well; VCC-well) qui est conçue en forme de cuvette dans le substrat (Sub) et qui est reliée de manière électriquement conductrice à la barre de potentiel (P1 ; P2).

2. Circuit intégré à semi-conducteurs selon la revendication 1, **caractérisé par le fait qu'**il est prévu entre la structure de protection (VSS-well ; VCC-well) et la barre de potentiel (P1 ; P2) correspondante une zone (Reg) qui a un dopage plus grand à celui de la structure de protection (VSS-well ; VCC-well).

3. Circuit intégré à semi-conducteurs selon la revendication 1 ou 2, **caractérisé par le fait qu'**au moins l'une des structures de protection (VSS-well, VCC-well) va jusqu'à la borne (PI, PO) concernée.

4. Circuit intégré à semi-conducteurs selon l'une des revendications 1, 2 ou 3, **caractérisé par le fait que** les structures de protection (VSS-well, VCC-well) ont au moins 5 µm de large.

5. Circuit intégré à semi-conducteurs selon l'une des revendications 1, 2 ou 3, **caractérisé par le fait que** la largeur d'une structure de protection (VSS-well; VCC-well) vaut au moins 10 % de la largeur de la barre de potentiel (P1 ; P2) qui se trouve au-dessus.

6. Circuit intégré à semi-conducteurs selon l'une des revendications précédentes, **caractérisé par le fait qu'**au moins l'une des structures de protection (VSS-well; VCC-well) est d'un type de conductivité qui est opposé au type de conductivité du substrat semi-conducteur (Sub).

7. Circuit intégré à semi-conducteurs selon l'une des revendications précédentes, **caractérisé par le fait qu'**au moins l'une des structures de protection (VSS-well; VCC-well) est du même type de conductivité que le type de conductivité du substrat semi-conducteur (Sub).

8. Circuit intégré à semi-conducteurs selon l'une des revendications précédentes, **caractérisé par le fait que** le substrat semi-conducteur (Sub) est prévu sur une couche épitaxiale (Epi).

9. Circuit intégré à semi-conducteurs selon l'une des revendications précédentes, **caractérisé par le fait qu'**une borne (PI) destinée à un conducteur (LI) pour un signal d'entrée (IN) et une borne (PO) destinée à un conducteur (LO) pour un signal de sortie (OUT) coïncident et forment ainsi une borne physique commune (PIO) par l'intermédiaire de laquelle aussi bien le signal d'entrée (IN) que le signal de sortie (OUT) peuvent passer et un premier circuit de protection (PADIN) destiné au signal d'entrée (IN) est en même temps un circuit de protection (PADOUT) destiné au signal de sortie (OUT).

10. Circuit intégré à semi-conducteurs selon l'une des revendications précédentes, **caractérisé par le fait que** les conducteurs supplémentaires (LO1) sont de plus basse impédance que le conducteur (LO) pour le signal de sortie (OUT) considéré.

11. Circuit intégré à semi-conducteurs selon la revendication 10, **caractérisé par le fait que** les conducteurs (LO) pour un signal de sortie (OUT) considéré ont une résistance d'au moins 2 Ohm.

12. Circuit intégré à semi-conducteurs selon la revendication 10 ou 11, **caractérisé par le fait que** la résistance d'un conducteur (LO) considéré pour un signal de sortie (OUT) est répartie régulièrement sur la zone entre la borne (PO ; PIO) et la seconde partie de circuit (CKT-O) concernée.

13. Circuit intégré à semi-conducteurs selon l'une des revendications précédentes, **caractérisé par le fait que** les zones en forme de cuvettes (S-well, D-well) en dessous du transistor à oxyde de champ (FOX) d'un circuit de protection (PADIN ; PADOUT) présentent un écart mutuel (A) qui est au maximum égal à l'écart minimal correspondant d'autres zones apparaissant en dehors du dispositif de protection du circuit à semi-conducteurs, en forme de cuvettes, ayant des potentiels différents et de même type de conductivité que les zones en forme de cuvettes (S-well, D-well) du transistor à oxyde de champ (FOX).

14. Circuit intégré à semi-conducteurs selon l'une des revendications précédentes, **caractérisé par le fait que** les zones de source et de drain (S, D) des transistors à oxyde de champ (FOX) des premiers circuits de protection (PADIN) sont reliées électriquement par l'intermédiaire de plusieurs contacts à la zone en forme de cuvette (S-well ; D-well) qui se trouve en dessous.

15. Circuit intégré à semi-conducteurs selon la revendication 14, **caractérisé par le fait que** les zones en forme de cuvettes (S-well ; D-well) des premiers circuits de protection (PADIN) comportent, en plus, une zone à dopage plus grand (Reg) par l'intermédiaire de laquelle s'effectue le contact avec les zones de source et de drain (S, D) des transistors à oxyde de champ (FOX).

16. Circuit intégré à semi-conducteurs selon l'une des revendications précédentes, **caractérisé par le fait que** les zones de source et de drain (S, D) des transistors à oxyde de champ (FOX) des seconds circuits de protection (PADOUT) sont reliées électriquement par l'intermédiaire de plusieurs contacts à la zone en forme de cuvette (S-well ; D-well) qui se trouve en dessous.

17. Circuit intégré à semi-conducteurs selon la revendication 16, **caractérisé par le fait que** les zones en forme de cuvettes (S-well ; D-well) des seconds circuits de protection (PADOUT) comportent, en plus, une zone à dopage plus grand (Reg), par l'intermédiaire de laquelle s'effectue le contact avec les zones de source et de drain (S, D) des transistors à oxyde de champ (FOX).

18. Circuit intégré à semi-conducteurs selon l'une des revendications précédentes, **caractérisé par le fait que** les transistors à oxyde de champ (FOX) des premiers circuits de protection (PADIN) sont conçus sous forme de transistors à doigts.

19. Circuit intégré à semi-conducteurs selon l'une des revendications précédentes, **caractérisé par le fait que** les transistors à oxyde de champ (FOX) des seconds circuits de protection (PADOUT) sont conçus sous forme de transistors à doigts.

20. Circuit intégré à semi-conducteurs selon la revendication 18 ou 19, **caractérisé par le fait que**, dans les coins des transistors à doigts, au moins les bouts des doigts sont biseautés.

21. Circuit intégré à semi-conducteurs selon l'une des revendications précédentes, **caractérisé par le fait que** la résistance à diffusion (Rdif) a une structure à grande surface.

22. Circuit intégré à semi-conducteurs selon l'une des revendications précédentes, **caractérisé par le fait que** les circuits de protection (PADIN, PADOUT) sont prévus à proximité immédiate de la borne (PI, PO, PIO) concernée.

23. Circuit intégré à semi-conducteurs selon l'une des revendications précédentes, **caractérisé par le fait que** la diode commandée par champ (ZVT) est réalisée sous forme de transistor neutre.

24. Circuit intégré à semi-conducteurs selon la revendication 23, **caractérisé par le fait que** la grille (G) du transistor neutre (ZVT) est conçue en forme d'os.

25. Circuit intégré à semi-conducteurs selon la revendication 23 ou 24, **caractérisé par le fait que**, pour un transistor neutre (ZVT), la grille est à une distance (A) de la source respective et du drain respectif, distance (A) qui vaut au moins 1,5 fois la distance minimale correspondante de transistors contenus dans le circuit à semi-conducteurs en dehors du dispositif de protection.

26. Circuit intégré à semi-conducteurs selon l'une des revendications précédentes, **caractérisé par le fait qu'**au moins un transistor Pass-Gate (PGT) est branché en aval d'un premier circuit de protection (PADIN).

27. Circuit intégré à semi-conducteurs selon la revendication 26, **caractérisé par le fait que** la grille du transistor Pass-Gate (PGT) est reliée au second potentiel d'alimentation (VCC).

28. Circuit intégré à semi-conducteurs selon la revendication 26, **caractérisé par le fait que** le transistor Pass-Gate (PGT) peut être commuté (Φ) au moyen de sa grille.

29. Circuit intégré à semi-conducteurs selon l'une des revendications 26 à 28, **caractérisé par le fait que** la grille du transistor Pass-Gate (PGT) est à une distance (B) de sa source et de son drain, distance (B) qui vaut au moins 1,5 fois la distance minimale correspondante de transistors contenus dans le circuit à semi-conducteurs en dehors du dispositif de protection.

30. Circuit intégré à semi-conducteurs selon l'une des revendications 1 à 29, **caractérisé par le fait que** la zone de source (S) du transistor à oxyde de champ (FOX) d'au moins l'un des circuits de protection (PADIN, PADOUT) est reliée à la première barre de potentiel (P1) par l'intermédiaire d'une couche molybdène-silicium (MoSi).

31. Circuit intégré à semi-conducteurs selon l'une des revendications 1 à 29, **caractérisé par le fait que** la zone de source (S) du transistor à oxyde de champ (FOX) d'au moins l'un des circuits de protection (PADIN, PADOUT) est reliée à la première barre de potentiel (P1) en utilisant une résistance (R) dont la valeur vaut au moins 5 fois la valeur qui existerait si la liaison était effectuée sans la résistance (R).

32. Circuit intégré à semi-conducteurs selon l'une des revendications 1 à 31, **caractérisé par le fait que** la zone de drain (D) du transistor à oxyde de champ (FOX) d'au moins l'un des circuits de protection (PADIN, PADOUT) est reliée au conducteur (LI ; LO1) pour le signal (IN ; OUT) respectif par l'intermédiaire d'une couche molybdène-silicium (MoSi).

33. Circuit intégré à semi-conducteurs selon l'une des revendications 1 à 31, **caractérisé par le fait que** la zone de drain (D) du transistor à oxyde de champ (FOX) d'au moins l'un des circuits de protection (PADIN, PADOUT) est reliée au conducteur (LI ; LO1) pour le signal (IN ; OUT) respectif, en utilisant une résistance (R) dont la valeur vaut au moins 5 fois la valeur qui existerait si la liaison était effectuée sans la résistance (R).

34. Circuit intégré à semi-conducteurs selon l'une des revendications précédentes, **caractérisé par le fait qu'**il est prévu, entre les deux barres de potentiel (P1, P2), au moins une diode (Dd) qui est bloquante lors du fonctionnement habituel du circuit à semi-conducteurs.

35. Circuit intégré à semi-conducteurs selon la revendication 34, **caractérisé par le fait qu'**il est prévu plus d'une diode (Dd) et qu'elles sont disposées à des intervalles mutuels de 10 mm au maximum.

36. Circuit intégré à semi-conducteurs selon la revendication 35, **caractérisé par le fait que** les diodes (Dd) sont prévues à intervalles réguliers.

37. Circuit intégré à semi-conducteurs selon l'une des revendications précédentes, **caractérisé par le fait qu'**il est prévu, entre les barres de potentiel (P1, P2), au moins un transistor à oxyde de champ (FOX-V), dont la grille est reliée à la seconde barre de potentiel (VCC).

38. Circuit intégré à semi-conducteurs selon la revendication 37, **caractérisé par le fait qu'**il est prévu plusieurs transistors à oxyde de champ (FOX-V) à des intervalles mutuels de 10 mm au maximum.

39. Circuit intégré à semi-conducteurs selon la revendication 38, **caractérisé par le fait que** les transistors à oxyde de champ (FOX-V) sont prévus à intervalles réguliers.

40. Circuit intégré à semi-conducteurs selon l'une des revendications précédentes, **caractérisé par le fait que**, lorsqu'il y a plusieurs barres de potentiel (P1-1, P1-2 ; P2-1, P2-2) auxquelles s'appliquent, lors du fonctionnement, le même potentiel d'alimentation (VSS ; VCC), ces barres de potentiel (P1-1, P1-2 ; P2-1, P2-2) sont reliées entre elles par l'intermédiaire d'au moins une paire de deux dispositifs à diodes (D1, D2) branchés en un montage antiparallèle.

41. Circuit intégré à semi-conducteurs selon la revendication 40, **caractérisé par le fait qu'**un dispositif à diodes (D1, D2) comporte une ou plusieurs diodes (D1-1, D1-2 ; D2-1, D2-2) branchées en série.

42. Circuit intégré à semi-conducteurs selon la revendication 40 ou 41, **caractérisé par le fait que** les paires de dispositifs à diodes (D1, D2) sont reliées en étoile à la barre de potentiel (P1 ; P2) qui présente la plus petite résistance ohmique (R3).

43. Circuit intégré à semi-conducteurs selon l'une des revendications 40 à 42, **caractérisé par le fait que**, dans le cas où plusieurs barres de potentiel (P1-1, P1-2 ; P2-1, P2-2) auxquelles s'appliquent, lors du fonctionnement, le même potentiel d'alimentation (VSS VCC), comportent chacune une borne de potentiel (P-VSS ; P-VCC) propre, les paires de dispositifs à diodes (D1, D2) sont reliées aux bornes de potentiel (P-VSS ; P-VCC) concernées.

44. Circuit intégré à semi-conducteurs selon la revendication 43, **caractérisé par le fait que** les paires de dispositifs à diodes (D1, D2) sont reliées en étoile à celle des bornes de potentiel (P-VSS, P-VCC) des barres de potentiel (P1-1, P1-2, P1-3 ; P2-1, P2-2, P2-3) présentant le même potentiel, dont la barre de potentiel (P1 ; P2) raccordée présente la plus petite résistance ohmique (R3).

45. Circuit intégré à semi-conducteurs selon l'une des revendications précédentes, **caractérisé par le fait que** le circuit à semi-conducteurs comporte au moins une borne (P-VBB), à laquelle s'applique, lors du fonctionnement du circuit à semi-conducteurs, un potentiel de polarisation de substrat (VBB), il est prévu entre cette borne (P-VBB) et la première barre de potentiel (P1) un transistor à oxyde de champ (FOX-B) dont la grille est reliée à cette borne (P-VBB), et, pour le transistor à oxyde de champ (FOX-B), une autre zone en forme-de cuvette (VBB-well) est constituée soit au moins en partie en dessous de la zone de drain (D), soit au moins en partie en dessous de la zone de source (S).
